# EUROPÄISCHE PATENTANMELDUNG

(11) **EP 0 531 984 A1**
(43) Veröffentlichungstag der Anmeldung: **17.03.1993**
(21) Anmeldenummer: 92115454.8
(22) Anmeldetag: 10.09.1992
(51) Int. Cl.: H01L 25/07, H01L 23/495

(54) **Elektronische Schaltung für Leistungshalbleiterbauelemente**

(30) Priorität: 11.09.1991 DE 4130160
(71) Anmelder: EXPORT-CONTOR Aussenhandelsgesellschaft mbH, D-90253 Nürnberg (DE)
(72) Erfinder: Göbl, Christian, W-8500 Nürnberg 70 (DE); Heilbronner, Heinrich, Dr., W-8504 Stein (DE); Tursky, Werner, Dr., W-8540 Schwabach (DE)

(57) **Zusammenfassung**

Es wird eine Schaltungsanordung für Leistungshalbleiterbauelemente beschrieben, bei der eine Trägerplatte [14], auf der mindestens ein Halbleiterbauelement [16] und Kontaktflächen [18] vorgesehen sind, mittels Leiterteile [22, 26] als Verbindungselemente elektrisch leitend untereinander und zur äußeren Kontaktierung verbunden werden.

## Beschreibung

Die Erfindung betrifft eine elektronische Schaltung, insbesonders Leistungshalbleiterschaltung gemäß dem Oberbegriff des Anspruchs 1.

Es sind elektronische Schaltungen bekannt, die auf einem oder mehreren isolierenden Substraten mittels auf dem Substrat festhaftender, strukturierter Kontaktflächen und darauf angebrachten Halbleitertabletten Anschlußleiter aufweisen, welche die Schaltung in einer geometrisch definierten Weise mit externen Strom- und Steueranschlüssen verbinden. Die Geometrie der Kontaktflächen auf dem Substrat stellt dabei die entsprechende Schaltung dar, wobei die Halbleiteroberflächen und die Kontaktflächen noch mittels interner Leiter (beispielsweise Bonddrähte) entsprechend verbunden sind. Dabei werden alle notwendigen elektrischen Verbindungen so auf Substratebene ausgebildet, daß auf einem Substrat für einen Anschluß nach außen immer nur ein bestimmter Anschlußleiterkontakt existiert. Besonders bei Leistungshalbleiterschaltungen mit erheblichen Stromdichten erfordert das auf Substratebene eine dem ohm'schen Widerstand der Leiterbahnen angepaßte Bahnbreite und eine erzwungene Geometrie der Kontaktflächen als Leiterstruktur, die der optimalen thermischen Verteilung der wärmeerzeugenden Halbleitertabletten auf dem auch zu Kühlzwecken dienenden Substrat nicht Rechnung trägt. Da auf Substratebene beispielsweise sich kreuzende Leiterstrukturen nicht möglich sind, ergeben sich Umwege und Umgehungen, die einer optimalen Struktur entgegen stehen.
Des weiteren ergibt sich daraus eine erhebliche Flächenausdehnung, welche die Kosten für Substrat und anschließendem Gehäuse erhöht. Des weiteren weisen Leiterteile die auf Substratebene angeordnet sind eine höhere Leitungsinduktivität auf, als beispielsweise übereinander in kleinerem Abstand verlaufende Leiterteile, was bei Schaltvorgängen zu höheren Überspannungen führt.

Der Erfindung liegt die Aufgabe zugrunde, eine elektronische Schaltungsanordnung, insbesonders eine Leistungshalbleiterschaltung zu schaffen, die bei gegebener Substratfläche optimierte ohm'sche Widerstände und niedrige elektrische Induktionswerte der Leitungen ergibt, sowie zuläßt, die wärmeerzeugenden Halbleitertabletten so anzuordnen, daß sich eine optimierte Ausnützung der Substratfläche zu Wärmeableitung ergibt, was beispielsweise durch eine möglichst gleichmäßige Verteilung der Wärmequellen über die Substratfläche gegeben ist. Diese Aufgabe wird erfindungsgemäß durch die Merkmale des kennzeichnenden Teiles des Anspruchs 1 gelöst. Weiterbildungen der erfindungsgemäßen elektronischen Schaltungsanordnung sind in den Unteransprüchen gekennzeichnet.

Mit der erfindungsgemäßen Ausbildung der Schaltungsanordnung ergibt sich der Vorteil eines kompakten, kostengünstigen Aufbaues, der auf einer gegebenen Grundfläche eine hohe Stromdichte ermöglicht und der durch eine flexible Anordnung der Anschlußleiter an die konstruktiven und elektrischen Notwendigkeiten beispielsweise einer Stromrichterschaltung anpaßbar ist.

Die Einzelheiten, Merkmale und Vorteile ergeben sich aus der nachfolgenden Beschreibung von den schematisch dargestellten Ausführungsbeispielen der erfindungsgemäßen elektronischen Schaltungsanordnung und deren Erklärungen.

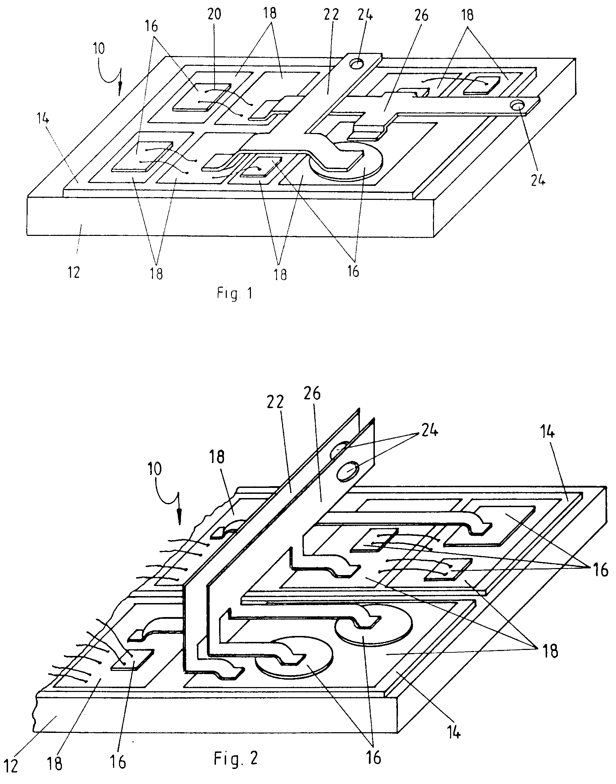

Fig. 1 zeigt schematisch das Grundprinzip der Erfindung auf: Eine elektronische Schaltungsanordnung [10] mit einer Kühlplatte [12], die auch als Kühlkörper mit Kühlrippen ausgebildet sein kann, an der in an sich bekannter Weise ein elektrisch isolierendes Substrat [14] befestigt ist, wird durch die Halbleiterelemente [16] und die Kontaktflächen [18] gebildet, wobei innere Anschlußleiter [20], beispielsweise als Bonddrähte, notwendige Verbindungen zwischen den Halbleiterelementen und den auf der Oberseite des Substrates festhaftenden Kontaktflächen [18] herstellen.

Erfindungsgemäß besteht die elektronische Schaltung aus weiteren, außerhalb des Substrates verlaufenden Anschlußleitern [22, 26] die zwei Funktionen besitzen:
a) die Verbindung von getrennt liegenden Kontaktflächen [18] untereinander oder zwischen Kontaktflächen [18] und Halbleiterelement [16] herzustellen
b) mittels äußerer Anschlüsse [24] die Verbindung nach außen zum Zweck des Anschlusses der Schaltung an den Strom- oder Steuerkreis zu ermöglichen.

Durch die Anordnung der Anschlußleiter [22, 26] über dem Substrat wird eine Leitungsführung auf dem Substrat vermieden, was im Fall des Stromverlaufs des gezeichneten Beispiels zu einem hohen Flächenverbrauch auf dem Substrat führen würde, da die Anschlußleiter [22, 26] durch ihre mehrlagige Anordnung Kreuzungen ermöglichen und weiter durch ihren geringen Abstand zu den stromführenden Kontaktflächen [18] einen niedrigen Induktivitätswert aufweisen. Außerdem können die Anschlußleiter [22, 26] durch eine entsprechend gewählte Stärke des Leiters kompakter ausgeführt werden, als die Leiterschicht der Kontaktflächen [18], die auf dem Substrat vornehmlich nur in einer begrenzten Schichtstärke ausgeführt werden kann.

Die Anschlußleiter [22, 26] gemäß der Erfindung können einstückig oder auch mehrstückig zusammengesetzt verbunden ausgeführt werden.

Die Verbindung der Anschlußleiter [22, 26] mit den Kontaktflächen [18] oder den Halbleitertabletten [16] kann stoffschlüssig mittels Löt-, Schweiß-Bondverbindung oder loslösbar mittels Druckkontakt hergestellt werden.

Durch eine entsprechende geometrische Formgebung der Anschlußleiter [22, 26] kann die Lage der äußeren Anschlüsse [24] an jeder Umfangsstelle des Substrates [14] oder der Kühlplatte [12] wählbar, den konstruktiven Anforderungen der Stromrichterschaltung gemäß, festgelegt werden.

Die in Fig. 2 angedeutete elektronische Schaltungsanordnung [10] unterscheidet sich von der in Fig. 1 gezeigten Ausbildung dadurch, daß die Ebene der Anschlußleiter [22, 26] einen bestimmten Winkel (beispielsweise 90°) zur Ebene der Kontaktflächen [18] des Substrates [14] einnimmt und daß die Anschlußleiter [22, 26] nahe beieinander geführt werden können, was in bestimmten Stromrichterschaltungen zu einer sehr kompakten Bauweise und zu niedrigen Induktivitätswerten der Leiterführung führt. Des weiteren sei hier angedeutet, daß durch die Anschlußleiter [22, 26] auch mehrere Substrate nach den Ansprüchen der Erfindung verbunden werden können.

## Patentansprüche

1. Halbleiterschaltung [10], insbesondere Leistungshalbleiterschaltung, bestehend aus mindestens einem isolierenden Substrat [14] mit darauf angebrachten Kontaktflächen [18] und daran angebrachten Halbleitertabletten [16] und aus mindestens einem metallischen Leiterteil [22, 26]
**dadurch gekennzeichnet**, daß
das mindestens eine Leiterteil [22, 26] außerhalb der Fläche des mindestens einen Substrates [14] verläuft und mindestens eine Kontaktfläche [18] und mindestens eine Halbleitertablette [16] des mindestens einen Substrates [14] oder mehrere Kontaktflächen [18] des mindestens einen Substrates [14] elektrisch verbindet und einen äußeren Anschluß [24] aufweist.

2. Halbleiterschaltung [10] nach Anspruch 1 dadurch gekennzeichnet, daß die Verbindung zwischen Kontaktfläche [18] oder Halbleitertablette [16] und dem Leiterteil [22, 26] durch stoffschlüssigen Kontakt hergestellt wird.

3. Halbleiterschaltung [10] nach Anspruch 1 dadurch gekennzeichnet, daß die Verbindung zwischen Kontaktfläche (18) oder Halbleitertablette [16] und dem Leiterteil [22, 26] durch loslösbaren Kontakt hergestellt wird.

4. Halbleiterschaltung [10] nach Anspruch 1 dadurch gekennzeichnet, daß das mindestens eine Leiterteil [22, 26] in wesentlichen Abschnitten parallel zur Substratfläche verläuft.

5. Halbleiterschaltung [10] nach Anspruch 1 dadurch gekennzeichnet, daß die Leiterteile [22, 26] zueinander oder zu den Kontaktflächen [18] des mindestens einen Substrates [14] im geringen Abstand verlaufen.

6. Halbleiterschaltung [10] nach Anspruch 1 und 5 dadurch gekennzeichnet, daß die Leiterteile [22, 26] voneinander oder von Kontaktflächen [18] mit einem dünnen Isolator elektrisch getrennt werden.

7. Halbleiterschaltung [10] nach Anspruch 1 dadurch gekennzeichnet, daß die Leiterteile [22, 26] aus mehreren Leiterstücken bestehen, die untereinander verbunden sind.

8. Halbleiterschaltung [10] nach Anspruch 1 dadurch gekennzeichnet, daß ein Leiterteil [22, 26] die gleichnamigen Elektroden mehrerer Halbleitertabletten [16] miteinander verbindet.
